# EUROPÄISCHE PATENTSCHRIFT

(11) **EP 1 612 917 B1**
(45) Veröffentlichungstag und Bekanntmachung des Hinweises auf die Patenterteilung: **21.09.2011**
(21) Anmeldenummer: 05105206.6
(22) Anmeldetag: 14.06.2005
(51) Int. Cl.: H02K 5/10, H05K 5/06, H02K 5/22, H02K 7/116, H02K 15/14

(54) **Gehäuseteil mit einem axialen Spielausgleichselement, sowie Herstellungsverfahren eines solchen**
Housing part including an axial play compensating element, and corresponding manufacturing method
Part d' un carter avec un élement pour compenser le jeu axial, et procédé correspondant

(30) Priorität: 29.06.2004 DE 102004031319
(43) Veröffentlichungstag der Anmeldung: 04.01.2006
(73) Patentinhaber: Robert Bosch GmbH, 70442 Stuttgart (DE)
(72) Erfinder: Maerkle, Jens, 77815 Buehl (DE)

(56) Entgegenhaltungen:
- DE-A1- 4 041 424
- DE-A1- 19 527 206
- DE-A1- 19 803 358
- DE-A1- 19 947 438
- DE-C1- 4 324 913
- FR-A- 1 348 886
- GB-A- 2 258 766

## Beschreibung

### Stand der Technik

Die Erfindung betrifft ein Gehäuseteil für eine Antriebseinheit mit einem axialen Spielausgleichselement, sowie ein Verfahren zum Herstellen eines solchen nach der Gattung der unabhängigen Ansprüche.

Mit der DE 200 04 338 U1 ist eine Antriebseinheit bekannt geworden, bei der ein Getriebegehäuse mit einem als Einschubmodul ausgebildeten Gehäuseteil verschlossen wird. Das Gehäuseteil weist dabei eine im wesentlichen rechteckige Radialdichtung auf, die beim Einführen in ein näherungsweise rechteckigen Schacht des Getriebegehäuses an eine radiale Wand desselben gepresst wird. Da die Anpresskräfte der Radialdichtung näherungsweise senkrecht zur axialen Montagerichtung angreifen, ist das Gehäuseteil mit separaten Verbindungsmittel am Gehäuse befestigt, wozu am Gehäuseteil Befestigungsbohrungen zur Aufnahme der Verbindungsmittel angeformt sind. Die Verwendung von separaten Verbindungsmitteln erfordert einen separaten Montageschritt und erhöht die Bauteilevielfalt, was für eine vollautomatische Fertigung unerwünscht ist.

Die GB 2 258 766 A zeigt ein Gehäuseteil, das vollständig aus einem einzigen Kunststoffmaterial hergestellt ist. Die Dichtwirkung des Gehäuseteils sowie die axiale Spielausgleichseignung scheint verbesserungsbedürftig.

Als weiterer Stand der Technik seien die DE 199 47 438 A1, die FR 1.348.886 A, die DE 198 03 358 A1, die DE 195 27 206 A1, die DE 43 24 913 C1 und die DE 40 41 424 A1 genannt.

### Vorteile der Erfindung

Das erfindungsgemäße Gehäuseteil hat den Vorteil, dass durch das Anformen von axialen Spielausgleichselementen auf separate Verbindungsmittel zwischen dem Gehäuseteil und dem Gehäuse verzichtet werden kann. Anstelle der separaten Verbindungsmittel können am Gehäuseteil und am Gehäuse jeweils Rast- und Gegenrastelemente angeformt werden, wodurch die Teilevielfalt reduziert wird und ein zusätzlicher Montageschritt entfällt. Dabei erzeugen die Spielausgleichselemente, die mit einer axialen Anschlagsfläche am Gehäuse anliegen, eine elastische Rückstellkraft in axialer Montagerichtung, die für eine zuverlässige Fixierung der Rastelemente sorgen. Bei der Radialdichtung sind im Vergleich zu einer Axialdichtung deutlich geringere Montagekräfte für das Gehäuseteil notwendig. Die in Axialrichtung wirkenden Kräfte sind lediglich zur spielfreien axialen Fixierung des Bauteils und nicht zu dessen Abdichtung notwendig. Auf diese Weise kann kosten- und montagegünstig ein spielfreier Sitz eines Elektronikmoduls in einem Einschubschacht einer Antriebseinheit realisiert werden, wobei Vibrationsgeräusche wirksam unterbunden werden.

Durch die in den Unteransprüche ausgeführten Merkmale sind vorteilhafte Weiterbildungen des erfindungsgemäßen Gehäuseteils, sowie dessen Herstellungsverfahrens möglich. Im Gegensatz zu einer axialen Dichtung können die Dichtlippen der Radialdichtung nicht gleichzeitig eine elastische Anlagefläche für die Verbindung des Gehäuseteils mit dem Gehäuse bilden. Daher bilden hier die Spielausgleichselemente eine separate Anschlagsfläche, die sich axial über die radiale Dichtfläche erstreckt und axial beabstandet zu derselben angeordnet ist. Dies ermöglicht einen tieferen Eingriff der Radialdichtung in die Öffnung des Gehäuses, bis eine Stirnfläche des Gehäuses an der Anschlagsfläche des Gehäuseteils anliegt, wodurch eine zuverlässige Abdichtung gewährleistet ist.

Um eine ausreichende Rückstellkraft im Bereich der Rastelemente zu erzielen, sind die Spielausgleichselemente über den Umfang der Radialdichtung dort angeordnet, wo die Rastelemente angeformt sind.

Für eine im wesentlichen rechteckige Radialdichtung werden vorzugsweise vier Spielausgleichselemente, jeweils zwei, an den beiden Längsseiten des Rechtsecks angeordnet.

Für die axialen Spielausgleichselemente eignet sich derselbe elastische Werkstoff, wie für die Ausformung der Radialdichtung, beispielsweise ein Elastomer oder ein Thermoplast, wodurch zur Fertigung kein zusätzliches Material vorgehalten werden muss.

Besonders günstig ist es, die axialen Spielausgleichselemente einstückig in einem Arbeitsgang mit der Radialdichtung an das Gehäuseteil anzuspritzen. Hierzu kann recht kostengünstig ein Zwei-Komponenten-Spritzgussverfahren verwendet werden.

Damit die Spielausgleichselemente die Dichtwirkung der axialen Dichtfläche nicht beeinträchtigen, sind zwischen der radialen Dichtfläche und den Anschlagsflächen herstellungsbedingt axiale Stege angeordnet, wobei deren radiale Außenfläche radial beabstandet zur radialen Dichtfläche liegt.

In einer bevorzugten Ausführung sind die axialen Stege konisch ausgebildet, so dass beim axialen Einführen des Gehäuseteils dieses innerhalb der Öffnung des Gehäuses radial zentriert wird. Durch den axialen Abstand zur radialen Dichtfläche wird deren Dichtwirkung durch den Konus nicht beeinträchtigt.

Durch das Anspritzen der Radialdichtung in einer Ebene in etwa senkrecht zur Montagerichtung, ist der deckelförmige Grundkörper des Gehäuseteils zwecks Bauraumeinsparung relativ flach ausgebildet, wodurch über den gesamten Umfang der Radialdichtung ausreichende radiale Anpresskräfte wirksam werden.

In Abhängigkeit des verwendeten Materials der Spielausgleichselemente und der Ausbildung der Rastelemente kann in einfacher Weise über deren Form und deren Abmessung die erforderliche elastische Rückstellkraft eingestellt werden, um eine zuverlässige Verrastung der Rastelemente zu gewährleisten.

Besonders kostengünstig kann das Gehäuseteil mittels Spritzgussverfahren hergestellt werden, wobei das Anformen der axialen Fortsätze mit den Anschlagsflächen für das Gehäuse praktisch keine zusätzlichen Kosten verursacht. Die axialen Fortsätze können ebenso wie die Steigdome im Spritzgusswerkzeug ausgespart werden und mittels Anspritzen mit dem zuvor gefertigten Gehäuseteil-Grundkörper verbunden werden.

### Zeichnungen

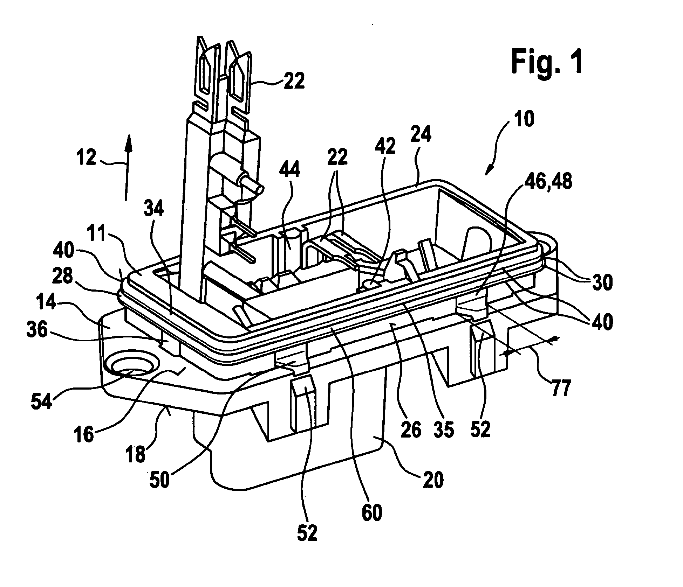

Es zeigen Figur 1
eine perspektivische Darstellung eines nicht erfindungsgemäßen Gehäuseteils zu Erläuterungszwecken,,

Figur 2
eine weitere Darstellung desselben Gehäuseteils zu Erläuterungszwecken und

Figur 3
einen Schnitt durch ein erfindungsgemäßes Ausführungsbeispiel eines Gehäuseteils und

Figur 4
eine perspektivische Darstellung eines geschlossenen Gehäuses einer Antriebseinheit

### Beschreibung des Ausführungsbeispiels

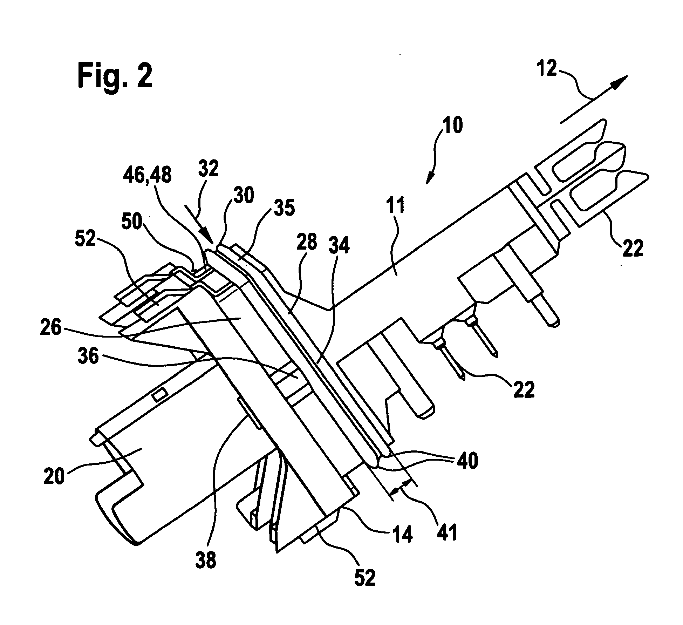

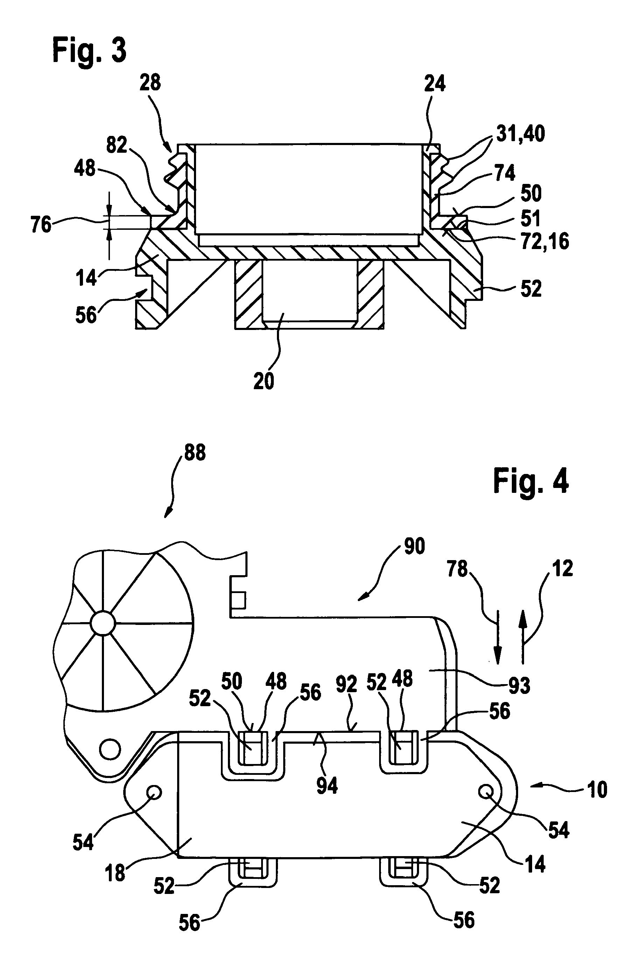

In Figur 1 ist ein Gehäuseteil 10 dargestellt, das geeignet ist, ein Getriebe- bzw. Elektronikgehäuse einer Antriebseinheit 88 wasserdicht abzuschließen. Das in Figur 4 näher dargestellte Gehäuse 90 der Antriebseinheit 88 weist beispielsweise eine in etwa rechteckige Öffnung 94 mit einer radialen Seitenwand 93 auf, in die zum Verschließen des Gehäuses 90 das Gehäuseteil 10 in axialer Richtung 12 eingeführt wird. Das Gehäuseteil 10 weist ein Deckelelement 14 mit einer Innenseite 16 und einer Außenseite 18 auf. An der Außenseite 18 ist beispielsweise ein Stecker 20 angeformt, wobei elektrische Kontakte 22 durch das Deckelelement 14 auf die Innenseite 16 durchgeführt werden. An der Innenseite 16 des Deckelelements 14 ist eine umlaufende Wand 24 mit einer radialen Außenfläche 26 angeformt, an der eine umlaufende Radialdichtung 28 angespritzt ist. Die Radialdichtung 28 ist näherungsweise rechteckig mit an den Ecken abgerundeten Radien 30 ausgebildet, um eine korrespondierende rechteckige Öffnung 94 im Gehäuse abzudichten. Die Radialdichtung 28 weist beispielsweise zwei oder mehrere Dichtlippen 31 auf, die eine radiale Dichtfläche 40 bilden, die eine axiale Ausdehnung 41 aufweist. Beim Einführen in das Gehäuse 90 wird die Radialdichtung 28 auf Grund auftretender Radialkräfte 32 (senkrecht zur Axialrichtung 12) gegen eine radiale Wand 93 des Gehäuses 90 gepresst und elastisch verformt. Jeweils etwa in der Mitte der kurzen Seite 34 der Radialdichtung 28 ist ein Steigdom 36 angeordnet, der sich ausgehend von der Radialdichtung 28 in axialer Richtung 12 erstreckt. Im Ausführungsbeispiel durchdringt der Steigdom 36 das Deckelelement 14 und bildet an der Außenseite 18 ein axiales Ende 38, wie dies in Figur 2 dargestellt ist. Um die Dichtwirkung der Radialdichtung 28 nicht zu beeinflussen, sind die Steigdome 36 radial versetzt, zur radialen Dichtfläche 40 angeordnet. Im Ausführungsbeispiel liegt beispielsweise eine äußere radiale Wand des Steigdoms 36 innerhalb der radialen Dichtfläche 40. Innerhalb der Radialdichtung 28 ist ebenfalls ein Anspritzpunkt 42 angeordnet, der über Verbindungsstücke 44 mit der Radialdichtung 28 verbunden ist. Dadurch, dass sowohl die Steigdome 36, als auch der Anspritzpunkt 42 nicht im Bereich der radialen Dichtfläche 40 angeordnet sind, ist diese besonders homogen, ohne Bindenaht und Anspritzstörungen ausgebildet. Zusätzlich zu den Steigdomen 36 sind an die Radialdichtungen 28 weitere axiale Fortsätze 46 angeformt, die als axiale Spielausgleichelemente 48 dienen. Die Spielausgleichselemente 48 stützen sich einerseits an der Innenseite 16 des Deckelelements 14 ab und bilden auf der gegenüberliegenden Seite eine axiale Anschlagsfläche 50 für das Gehäuse 90. Durch die Form und Abmessung der Spielausgleichselemente 48 kann eine Federkraft 78 eingestellt werden, die für eine Rastverbindung 52 zwischen dem Gehäuseteil 10 und dem Gehäuse 90 notwendig ist. Hierzu sind an dem Gehäuseteil 10 beispielsweise Rastnasen 52 ausgebildet, die in entsprechende Rastlaschen 56 des Gehäuses 90 eingreifen.

In Figur 2 ist deutlich zu erkennen, dass die axialen Fortsätze 46 der Spielausgleichselemente 48, ebenso wie die Steigdome 36, radial versetzt zur radialen Dichtfläche 40 angeordnet sind, so dass diese die axialen Wände des Gehäuses 90 beim axialen Einführen des Gehäuseteils 10 in das Gehäuse 90 nicht berühren. Die axialen Spielausgleichselemente 48 sind im Bereich der Rastelemente 52 angeordnet, die in einer alternativen Ausführung auch als Rastösen 56 ausgebildet sein können, in die entsprechende Rasthaken 52 des Gehäuses 90 eingreifbar sind.

Das Gehäuseteil 10 wird mittels eines Zwei-Komponenten-Spritzgussverfahren hergestellt, wobei in einem ersten Schritt ein Grundkörper aus einer ersten Komponente 11, beispielsweise Hartplastik gespritzt wird. Während dieses ersten Spritzvorgangs wird in die Werkzeugform ein Einsatz eingelegt, der die Form für die zweite Komponente 60 aufweist. Nach Entfernen des Einsatzes wird in einem zweiten Schritt die zweite Komponente 60 am Anspritzpunkt 42 in das Spritzgusswerkzeug eingespritzt, wobei als zweite Komponente 60 ein elastisches Material, vorzugsweise ein Elastomer oder Thermoplast verwendet wird. In einem alternativen Spritzguss-Verfahren werden die zwei Komponenten in zwei unterschiedlichen Nestern eines Werkzeugs angespritzt, wobei hier das Gehäuseteil 10 von einem Nest in das andere Nest umgesetzt wird.

Figur 3 zeigt einen Schnitt durch das Gehäuseteil 10. Die Radialdichtung 28 ist an die radiale Außenfläche 26 der umlaufenden Wand 24 angeformt. Daran anschließend erstreckt sich in axialer Richtung der axiale Fortsatz 46, der als axiales Spielausgleichelement 48 ausgebildet ist. Dabei ist an einem axialen Steg 74, der sich ausgehend von der Radialdichtung 28 axial erstreckt, die Anschlagsfläche 50 für eine Stirnfläche des Gehäuses 90 angeformt. Auf der der Anschlagsfläche 50 gegenüberliegenden Seite 51 stützt sich das axiale Spielausgleichselement 48 an einem axialen Bund 72 des Gehäuseteils 10 ab, das durch die Innenseite 16 des Deckelelements 14 gebildet wird. Dabei weist die radiale Dichtfläche 40 einen größeren Durchmesser auf, als die axialen Stege 74, die die Anschlagsfläche 50 mit den Dichtlippen 31 verbindet. Die axialen Spielausgleichselemente 48 weisen eine axiale Dicke 76 und eine Breite 77 auf, über die in Abhängigkeit des verwendeten elastischen Materials die Rückstellkraft 78 und der Federweg einstellbar sind. Auf der linken Seite der Figur 3 weist der axiale Steg 74 im Übergang zur Anschlagsfläche 50 einen Konus 82 auf, der beim axialen Einführen des Gehäuseteils 10 in axialer Richtung 12 das Gehäuseteil 10 innerhalb der Öffnung 92 im Gehäuse 90 radial zentriert. Bezüglich des Umfangs der Radialdichtung 28 ist im Bereich des Spielausgleichselements 48 am Gehäuseteil 10 jeweils ein Rastelement 52 ausgeformt, das beispielsweise als Rastnase 52 ausgebildet ist, die in eine korrespondierende Rastöse 56 des Gehäuses 90 eingreifbar ist.

In Figur 4 ist das Gehäuseteil 10 in ein Getriebe-Elektronikgehäuse 90 einer Antriebseinheit 88 eingefügt, wobei eine im wesentlichen rechteckige Öffnung 92 des Gehäuses 90 wasserdicht verschlossen wird. Dabei liegt die Anschlagsfläche 50 an einer Stirnseite 94 des Gehäuses 90 an, wobei das axiale Spielausgleichselement 48 eine elastische Rückstellkraft 78 erzeugt, die dafür sorgt, dass die Rastnasen 52 des Gehäuseteils 10 fest in den Rastösen 56 des Gehäuses 90 fixiert bleiben. Bei dieser Rastverbindung sind keine zusätzlichen Verbindungsmittel zur Befestigung des Gehäuseteils 10 notwendig.

Ein nicht näher dargestelltes Spritzgusswerkzeug zur Herstellung des Gehäuseteils 10 ist als schieberloses Werkzeug ausgebildet, und weist vorzugsweise eine Trennebene auf, die in der Diagonalen der im wesentlichen rechteckförmigen Radialdichtung 28 liegt. Dadurch kommen eventuell auftretende kleine Grate, die durch die Trennfläche verursacht werden, an den abgerundeten Ecken 30 auf. An diesen Ecken treten aber beim Einfügen des Gehäuseteils 10 in die radiale Wand 93 des Gehäuses 90 erhöhte Radialkräfte 32 auf, so dass geringe Unebenheiten in diesem Bereich die Dichtwirkungen nicht beeinträchtigen.

Es kann beispielsweise die konkrete Form und der Querschnitt der Radialdichtung 28 den entsprechenden Anwendungen angepasst werden. Ebenso kann die Anzahl und die Anordnung, sowie die Ausformung der Ausgleichselemente 48 und der Rastelemente 52, 56 variiert werden. Bevorzugt findet das erfindungsgemäße Gehäuseteil 10 Anwendung für Stellantriebe 88 im Kraftfahrzeug, beispielsweise für Elektronik-Module von Fensterheber- oder Schiebedachantrieben.

## Patentansprüche

1. Gehäuseteil (10) für eine Antriebseinheit (88), mit einer angeformten elastischen Radialdichtung (28), die eine radiale Dichtfläche (40) zum wasserdichten Abschließen eines Gehäuses (90) aufweist, wobei das Gehäuseteil (10) mittels angeformter Rastelemente (52, 56) mit entsprechenden Gegenrastelementen (56, 52) des Gehäuses (90) verbindbar ist, um das Gehäuseteil (10) axial am Gehäuse (90) zu fixieren, wobei an dem Gehäuseteil (10) elastische, axiale Spielausgleichselemente (48) ausgebildet sind, die axiale Anschlagsflächen (50) des Gehäuseteils (10) für das Gehäuse (90) bilden, **dadurch gekennzeichnet, dass** die axialen Spielausgleichselemente (48) einstückig mit der Radialdichtung (28) an einen aus Hartplastik gespritzten Grundkörper (11) des Gehäuseteils (10) angespritzt sind, und dass die axialen Spielausgleichselemente (48) und die Radialdichtung (28) aus demselben Elastomer oder demselben Thermoplast gefertigt sind.

2. Gehäuseteil (10) nach Anspruch 1, **dadurch gekennzeichnet, dass** die Anschlagsflächen (50) axial versetzt gegenüber der axialen Ausdehnung (41) der radialen Dichtfläche (40) angeordnet sind.

3. Gehäuseteil (10) nach einem der Ansprüche 1 oder 2, **dadurch gekennzeichnet, dass** die axialen Spielausgleichselemente (48) - insbesondre zwei bis vier - bezüglich der Umfangsrichtung der Radialdichtung (28) im Bereich der Rastelemente (52, 56) angeordnet sind.

4. Gehäuseteil (10) nach einem der vorgehenden Ansprüche, **dadurch gekennzeichnet, dass** das Gehäuseteil (10) ein Deckelelement (14) mit einer Innenseite (16) und einer Außenseite (18) aufweist, wobei an der Außenseite ein Stecker (20) angeformt ist.

5. Gehäuseteil (10) nach einem der vorgehenden Ansprüche, **dadurch gekennzeichnet, dass** die Radialdichtung (28) näherungsweise rechteckig mit an den Ecken abgerundeten Radien (30) ausgebildet ist, um eine rechteckige Öffnung (94) des Gehäuses (90) abzudichten.

6. Gehäuseteil (10) nach einem der vorgehenden Ansprüche, **dadurch gekennzeichnet, dass** die Anschlagsflächen (50) über axiale Stege (74) mit der Radialdichtung (28) verbunden sind, wobei die Stege (74) radial innerhalb der radialen Dichtfläche (40) angeordnet sind.

7. Gehäuseteil (10) nach Anspruch 6, **dadurch gekennzeichnet, dass** die axialen Stege (74) als Zentrierdome (82) ausgebildet sind, die das Gehäuseteil (10) radial innerhalb einer Öffnung (92) des Gehäuses (90) zentrieren.

8. Gehäuseteil (10) nach einem der vorgehenden Ansprüche, **dadurch gekennzeichnet, dass** die Radialdichtung (28) näherungsweise in einer radialen Ebene in etwa senkrecht zur Montagerichtung (12) des Gehäuseteils (10) angeordnet ist.

9. Gehäuseteil (10) nach einem der vorgehenden Ansprüche, **dadurch gekennzeichnet, dass** über die Form und Abmessung (76, 77) der Spielausgleichselemente (48) eine Rückstellkraft (78) zwischen der Anschlagsfläche (50) des Gehäuseteils (10) und einer korrespondierenden axialen Abstützfläche (94) des Gehäuses (90) einstellbar ist.

10. Gehäuseteil (10) nach einem der vorgehende Ansprüche, **dadurch gekennzeichnet, dass** an die Radialdichtung (28) zusätzlich zu Steigdomen (36) axiale Fortsätze (46) angeformt sind, die als axiale Spielausgleichselemente (18) dienen und ebenso wie die Steigdome radial versetzt zur radialen Dichtfläche derart angeordnet sind, dass die axialen Fortsätze (46) die axialen Wände des zu verschließenden Gehäuses nicht berühren.

## Claims

1. Housing part (10) for a drive unit (88), having an integrally formed elastic radial seal (28) which has a radial sealing face (40) for the watertight closure of a housing (90), it being possible for the housing part (10) to be connected by means of integrally formed latching elements (52, 56) to corresponding mating latching elements (56, 52) of the housing (90), in order to fix the housing part (10) axially on the housing (90), elastic, axial play compensation elements (48) being formed on the housing part (10), which play compensation elements (48) form axial stop faces (50) of the housing part (10) for the housing (90), **characterized in that** the axial play compensation elements (48) are injection-moulded in one piece with the radial seal (28) onto a basic body (11) of the housing part (10), which basic body (11) is injection-moulded from hard plastic, and **in that** the axial play compensation elements (48) and the radial seal (28) are produced from the same elastomer or the same thermoplastic.

2. Housing part (10) according to Claim 1, **characterized in that** the stop faces (50) are arranged axially offset with respect to the axial extent (41) of the radial sealing face (40).

3. Housing part (10) according to either of Claims 1 and 2, **characterized in that** the axial play compensation elements (48), in particular two to four, are arranged in the region of the latching elements (52, 56) with regard to the circumferential direction of the radial seal (28).

4. Housing part (10) according to one of the preceding claims, **characterized in that** the housing part (10) has a cover element (14) with an inner side (16) and an outer side (18), a plug (20) being formed integrally on the outer side.

5. Housing part (10) according to one of the preceding claims, **characterized in that** the radial seal (28) is of approximately rectangular configuration with radii (30) which are rounded at the corners, in order to seal a rectangular opening (94) of the housing (90).

6. Housing part (10) according to one of the preceding claims, **characterized in that** the stop faces (50) are connected via axial webs (74) to the radial seal (28), the webs (74) being arranged radially within the radial sealing face (40).

7. Housing part (10) according to Claim 6, **characterized in that** the axial webs (74) are configured as centring domes (82) which centre the housing part (10) radially within an opening (92) of the housing (90).

8. Housing part (10) according to one of the preceding claims, **characterized in that** the radial seal (28) is arranged approximately in a radial plane, approximately perpendicularly with respect to the mounting direction (12) of the housing part (10).

9. Housing part (10) according to one of the preceding claims, **characterized in that** a restoring force (78) between the stop face (50) of the housing part (10) and a corresponding axial supporting face (94) of the housing (90) can be set via the shape and dimension (76, 77) of the play compensation elements (48).

10. Housing part (10) according to one of the preceding claims, **characterized in that**, in addition to riser domes (36), axial projections (46) are integrally formed onto the radial seal (28), which axial projections (46) serve as axial play compensation elements (18) and, just like the riser domes, are arranged radially offset with respect to the radial sealing face in such a way that the axial projections (46) do not make contact with the axial walls of the housing to be closed.

## Revendications

1. Partie de carter (10) pour une unité d'entraînement (88), comprenant une garniture d'étanchéité radiale élastique façonnée (28), qui présente une surface d'étanchéité radiale (40) pour sceller de manière étanche à l'eau un carter (90), la partie de carter (10) pouvant être raccordée au moyen d'éléments d'encliquetage façonnés (52, 56) à des éléments d'encliquetage conjugués correspondants (56, 52) du carter (90), afin de fixer la partie de carter (10) axialement sur le carter (90), des éléments de compensation de jeu axiaux élastiques (48) étant réalisés sur la partie de carter (10), lesquels forment des faces de butée (50) de la partie de carter (10) pour le carter (90), **caractérisée en ce que** les éléments de compensation de jeu axiaux (48) sont moulés par injection d'une seule pièce avec la garniture d'étanchéité radiale (28) sur un corps de base (11) de la partie de carter (10) moulé par injection de plastique dur, et **en ce que** les éléments de compensation de jeu axiaux (48) et la garniture d'étanchéité radiale (28) sont fabriqués en le même élastomère ou le même thermoplastique.

2. Partie de carter (10) selon la revendication 1, **caractérisée en ce que** les faces de butée (50) sont disposées de manière décalée axialement par rapport à l'étendue axiale (41) de la surface d'étanchéité radiale (40).

3. Partie de carter (10) selon l'une quelconque des revendications 1 ou 2, **caractérisée en ce que** les éléments de compensation de jeu axiaux (48) - en particulier au nombre de deux à quatre - sont disposés par rapport à la direction périphérique de la garniture d'étanchéité radiale (28) dans la région des éléments d'encliquetage (52, 56).

4. Partie de carter (10) selon l'une quelconque des revendications précédentes, **caractérisée en ce que** la partie de carter (10) présente un élément de couvercle (14) avec un côté intérieur (16) et un côté extérieur (18), un connecteur à fiche (20) étant façonné sur le côté extérieur.

5. Partie de carter (10) selon l'une quelconque des revendications précédentes, **caractérisée en ce que** la garniture d'étanchéité radiale (28) est réalisée de manière approximativement rectangulaire avec des rayons (30) arrondis aux coins, afin de sceller une ouverture rectangulaire (94) du carter (90).

6. Partie de carter (10) selon l'une quelconque des revendications précédentes, **caractérisée en ce que** les faces de butée (50) sont connectées à la garniture d'étanchéité radiale (28) par le biais de nervures axiales (74), les nervures (74) étant disposées radialement à l'intérieur de la surface d'étanchéité radiale (40).

7. Partie de carter (10) selon la revendication 6, **caractérisée en ce que** les nervures axiales (74) sont réalisées sous forme de dômes de centrage (82), qui centrent la partie de carter (10) radialement à l'intérieur d'une ouverture (92) du carter (90).

8. Partie de carter (10) selon l'une quelconque des revendications précédentes, **caractérisée en ce que** la garniture d'étanchéité radiale (28) est disposée approximativement dans un plan radial approximativement perpendiculaire à la direction de montage (12) de la partie de carter (10).

9. Partie de carter (10) selon l'une quelconque des revendications précédentes, **caractérisée en ce que**, par le biais de la forme et de la dimension (76, 77) des éléments de compensation de jeu (48), une force de rappel (78) peut être ajustée entre la face de butée (50) de la partie de carter (10) et une face d'appui axiale correspondante (94) du carter (90).

10. Partie de carter (10) selon l'une quelconque des revendications précédentes, **caractérisée en ce que** des saillies axiales (46) sont façonnées sur la garniture d'étanchéité radiale (28) en plus de dômes de montée (36), lesquelles servent d'éléments de compensation de jeu axiaux (48) et sont disposées, tout comme les dômes de montée, de manière décalée radialement par rapport à la surface d'étanchéité radiale, de telle sorte que les saillies axiales (46) ne viennent pas en contact avec les parois axiales du carter à fermer.
